# EUROPÄISCHE PATENTANMELDUNG

(11) **EP 4 498 438 A1**
(43) Veröffentlichungstag der Anmeldung: **29.01.2025**
(21) Anmeldenummer: 24190268.3
(22) Anmeldetag: 23.07.2024
(51) Int. Cl.: H01L 31/048, H02S 20/26

(54) **KONSTRUKTIONSELEMENT IN GESTALT EINER INSBESONDERE SANDWICHARTIG AUFGEBAUTEN FASSADENPLATTE SOWIE VERFAHREN ZUM HERSTELLEN EINES SOLCHEN KONSTRUKTIONSELEMENTS**

(30) Priorität: 28.07.2023 DE 102023120206
(71) Anmelder: sedak GmbH & Co. KG, 86368 Gersthofen (DE)
(72) Erfinder: SCHLÖGL, Fritz, 86391 Stadtbergen (DE)
(74) Vertreter: Meissner Bolte Partnerschaft mbB

(57) **Zusammenfassung**

Die Erfindung betrifft ein Konstruktionselement (1) in Gestalt einer insbesondere sandwichartig aufgebauten Fassadenplatte. Das Konstruktionselement (1) weist einen Träger in Gestalt einer monolithisch ausgeführten Glasplatte (2) auf, welche eine Oberseite aufweist, die die Außenseite des insbesondere als Fassadenplatte ausgeführten Konstruktionselements (1) bildet. Das Konstruktionselement (1) weist ferner eine Vielzahl von in einer Reihe oder in einem Array angeordnete Photovoltaik-Module (3) auf. Erfindungsgemäß ist insbesondere vorgesehen, dass die Photovoltaik-Module (3) insbesondere im Zuge eines Autoklaven-Prozesses auf eine der Oberseite gegenüberliegenden Unterseite des Trägers (2) stoffschlüssig auflaminiert sind.

## Beschreibung

Die vorliegende Erfindung betrifft ein Konstruktionselement in Gestalt einer insbesondere sandwichartig aufgebauten Fassadenplatte mit einer optimierten Außenfläche.

Fassadenplatten für den Einsatz im Baubereich, insbesondere zur Dacheindeckung und Fassadenbekleidung, sind allgemein aus dem Stand der Technik bekannt. Sie bestehen üblicherweise aus zwei Außenplatten aus Blech oder PVC, zwischen denen sich sandwichartig eine Dämmschicht beispielsweise aus Polyurethanschaum befindet.

Beispielsweise wird ein Dämmpanel in der Druckschrift WO 2004/009929 A1 beschrieben. Das aus diesem Stand der Technik bekannte Panel besteht aus einem Paar sandwichartig verbundener Bleche mit dazwischenliegender Dämmschicht.

Die seit 2021 geltende EU-Gebäuderichtlinie fordert für neue Gebäude eine weitgehend ausgeglichene Energiebilanz (nearly zero energy). Von daher werden Dach- und Fassadenflächen zunehmend zur Energiegewinnung herangezogen. Besonders häufig wird hierzu die Solartechnik und die Photovoltaik eingesetzt.

Diese Produkte sind schon recht weit entwickelt. Allerdings haben diese Produkte den Nachteil, dass das äußere Erscheinungsbild der Fassade oder des Dachs in erster Linie von diesen Produkten geprägt wird.

Neben der beschriebenen Technik wird Energie auch aus Windkraftanlagen gewonnen. Hier haben sich in erster Linie Anlagen durchgesetzt, welche die Windkraft durch Rotoren verschiedener Art nutzen. Der Einsatz dieser Anlagen auf dem Dach oder an der Fassade sind zwar möglich und denkbar, aber auch diese Anlagen beeinflussen wesentlich das Erscheinungsbild des Gebäudes.

Andererseits werden Photovoltaikmodule heutzutage vielerorts eingesetzt, so dass ein möglicher Einsatzort für Photovoltaikanlagen auch Gebäudefassaden sind, man spricht in diesem Zusammenhang auch von "BIPV-Anwendungen". BIPV ist die Abkürzung der englischen Bezeichnung für gebäudeintegrierte Photovoltaik, "building-integrated photovoltaics". Im Deutschen wird bisweilen auch die Abkürzung der deutschen Bezeichnung, GIPV, verwendet.

Bei solchen BIPV-Anwendungen geht es nicht zwangsläufig darum, dass die verwendeten Photovoltaikmodule möglichst effizient elektrischen Strom produzieren. Vielmehr spielen bei der Integration von Photovoltaikmodulen in Gebäudefassaden auch ästhetische Aspekte eine entscheidende Rolle bei der Bewilligung von Bauprojekten.

Im Allgemeinen ist es ein Bestreben, den ökologischen Fußabdruck im Bereich des Gebäudesektors zu reduzieren. Dazu kann zum einen eine umweltschonende hauseigene Verwendung regenerativer Ressourcen beitragen, zum anderen jedoch auch eine umweltbewusste Gesamtbetrachtung beim Neubau oder auch hinsichtlich der Langlebigkeit von Gebäuden. Dies gilt umso mehr für den industriellen Bereich, in welchem etwa durch den Bau großer Fabrikhallen ein größerer Einfluss auf die Umwelt genommen wird.

Im Einzelnen spricht man von gebäudeintegrierter Photovoltaik (BIPV), wenn Solarmodule nicht auf das Dach gesetzt, sondern in die Gebäudehülle integriert werden. BIPV-Module bringen einige Vorteile mit sich, müssen aber auch bestimmte Anforderungen erfüllen.

BIPV-Module werden im Gegensatz zu den gängigen Solarmodulen selbst Bestandteil eines Gebäudes, entweder als Überdachung oder als Teil der Fassade.

Solarstrom zu erzeugen, ist häufig nicht die einzige Funktion von BIPV-Modulen. So bieten sie beispielsweise Schutz vor Witterung (Regen, Schnee und Sonne), kühlen als vorgehängte Fassade das Gebäude oder können als teiltransparente Solarmodule Tageslicht durchlassen, was eine zusätzliche Beleuchtung überflüssig macht und auch optische Akzente setzen. Darüber hinaus dienen sie als Gestaltungselemente, die das Gebäude ästhetisch aufwerten. Eingesetzt werden BIPV-Module häufig:
- als Indach-Module
- als Fassaden-PV-Module,
- für Solar-Carports oder Solarterrassen, und
- als Parkplatzüberdachungen.

Im weiteren Sinne gehören auch Solardachziegel in den Bereich der gebäudeintegrierten Photovoltaik. Aufgrund der relativ hohen Kosten und der Fehleranfälligkeit kommen Solardachziegel im privaten Bereich allerdings eher selten zum Einsatz - zum Beispiel dann, wenn andere Möglichkeiten wegen des Denkmalschutzes nicht infrage kommen.

Konkret ist es daher bereits seit langem bekannt, aus Sonnenstrahlung einerseits Strom andererseits auch Wärme zu gewinnen bzw. gezielt zu nutzen, um den Bezug externer Energiequellen zu reduzieren und ressourcenschonender vorzugehen. Insofern kann allgemein von einem Solarenergiegewinnungselement gesprochen werden, wozu etwa Photovoltaik-Module bzw. Photovoltaik-Paneele (kurz PV-Module bzw. PV-Paneele) zur Gewinnung elektrischen Stroms aus Sonneneinstrahlung oder aber auch Solarthermie-Module zur Nutzung der Wärme der Sonnenstrahlung gehören. Nachfolgend wird in diesem Zusammenhang abkürzend von einem Photovoltaik-Modul gesprochen. Darunter sollen auch kombinierte Elemente fallen, die sowohl über Photovoltaik-Paneele (nachfolgend kurz "PV-Paneele" genannt) elektrische Energie gewinnen als auch über Solarthermie die Wärme gezielt nutzen.

Auch werden häufig Wärmepumpen in die Energienutzung eines Gebäudes integriert, um den Verbrauch externen Ressourcen möglichst zu verringern.

Ein weiterer Aspekt hinsichtlich eines verbesserten ökologischen Fußabdrucks eines Gebäudes ist, zum einen die Baustellenstandzeit zur Herstellung des Gebäudes so kurz wie möglich zu halten, zum anderen jedoch auch möglichst langlebige Gebäude bereitzustellen, um möglichst lange ohne Ressourcen verbrauchende Restaurationsarbeiten aus zu kommen.

Vor diesem Hintergrund ist es beispielsweise lohnend, über den Einsatz von Fertigbauteilen zur Bereitstellung eines Gebäudes, vor allem einer Fassade, nachzudenken.

Andererseits ist das erklärte Ziel vieler Architekten und Designer, Glasfassaden und jegliche Art von Glaswänden oder Glasbauteilen möglichst großflächig auszuführen. Wenn hingegen eine Fassadenplatte einerseits möglichst großflächig ausgeführt sein soll und andererseits ein Photovoltaik-Modul aufweisen soll, entsteht ein Widerspruch, da herkömmliche auf dem Markt erhältliche Photovoltaik-Module eine bestimmte Abmessung nicht überschreiten können.

Vor diesem Hintergrund liegt der vorliegenden Erfindung die Aufgabe zugrunde, ein Fassadenelement zum Aufbau einer Fassade eines Gebäudes bereitzustellen, mit dem eine umweltfreundliche und schnelle Herstellung eines Gebäudes gelingen kann. Die Langlebigkeit der hergestellten Fassade sollte möglichst hoch sein, sowie optimalerweise auch ein ressourcenschonender Betrieb des Gebäudes möglich sein.

Weiterhin liegt der Erfindung die Aufgabe zugrunde, eine entsprechende Fassade eines Gebäudes bereitzustellen, welche Fassade auf einfache, umweltfreundliche und schnelle Weise hergestellt werden kann, eine Langlebigkeit gewährleistet, sowie vorzugsweise auch einen ressourcenschonenden Betrieb des Gebäudes ermöglicht.

Diese Aufgabe wird erfindungsgemäß insbesondere durch den Gegenstand des unabhängigen Patentanspruchs 1 gelöst, wobei vorteilhafte Weiterbildungen der Erfindung in den abhängigen Ansprüchen angegeben sind.

Demgemäß betrifft die Erfindung insbesondere ein Konstruktionselement in Gestalt einer insbesondere sandwichartig aufgebauten Fassadenplatte, wobei das Konstruktionselement einen Träger in Gestalt einer monolithisch ausgeführten Glasplatte aufweist. Die monolithisch ausgeführte Glasplatte weist eine Oberseite auf, welche die Außenseite des insbesondere als Fassadenplatte ausgeführten Konstruktionselements bildet.

Das Konstruktionselement weist ferner eine Vielzahl von in einer Reihe oder in einem Array angeordnete Photovoltaik-Module auf. Die Photovoltaik-Module sind stoffschlüssig mit einer der Oberseite gegenüberliegenden Unterseite des Trägers verbunden und insbesondere auflaminiert.

Im Einzelnen können die Photovoltaik-Module im Zuge eines insbesondere temperierten Vakuumprozesses und vorzugsweise mit Hilfe eines Autoklaven-Prozesses auf eine der Oberseite gegenüberliegenden Unterseite des Trägers auflaminiert worden sein.

Der erfindungsgemäße Ansatz sieht somit vor, vereinfachte, also nur mit einfachem dünnen Deckglas versehene und fertig angeschlossene sowie geprüfte PV-Module zu verwenden und diese im Autoklaven-Prozess auf eine übergroße insbesondere beschichtete Trägerscheibe aufzulaminieren. Die vorab schon verbundenen Module werden dadurch nicht mehr beschädigt, da die verlöteten PV-Zellen so bereits vollständig verkapselt sind. Zusätzlich können die einzelnen Module genauso wie separate nichtverbundene Module einzeln angeschlossen und elektrotechnisch konform angeschlossen werden.

Zum Auflaminieren auf das Trägerglas eignen sich dabei die bekannten Zellenmodule genauso wie die Dünnschichtmodule.

Der Begriff Photovoltaik (PV) bezeichnet hierin generell den Vorgang der Umwandlung von Sonnenenergie in elektrischen (nutzbaren) Strom.

Für die Erfindung ist vorzugsweise insbesondere auch die Technologie der flexiblen Dünnschicht-Solarmodule geeignet, insbesondere mit amorphen Siliziumzellen, welche dünn und zumindest in einer Richtung biegbar (krümmbar) sind. Sie werden auch als folienartig bezeichnet. Somit sind diese folienartigen PV-Elemente besonders geeignet, mit den ebenfalls dünnen, biegbaren und krümmbaren Flächengebilden, vorzugsweise hergestellt aus Folien oder Geweben, kombiniert oder verbunden zu werden.

Demnach ist gemäß Ausführungsvarianten vorgesehen, dass der in Gestalt einer monolithisch ausgeführten Glasplatte ausgeführte Träger als eine gebogene Glasscheibe mit einem vorab festgelegten oder festlegbaren Biegeradius ausgeführt ist.

Es können aber beispielsweise auch andere flexible Solarzellen, Solar(zellen)module und -Elemente eingesetzt werden, beispielsweise so genannte CIS- oder CIGS-Module, Grätzelzellen, organische Solarzellen etc.

Die Herstellung von übergroßen BIPV-Modulen für die anspruchsvolle Architektur ist ohne das neu entwickelte Verfahren bzw. ohne die vorliegende Erfindung nicht möglich. Es können die PV-Elementgrößen dem Fugenraster der großen Fassadengläser angepasst werden. Insbesondere gestattet die Erfindung die freie Gestaltung der energieerzeugenden Fassadenelemente vorzugsweise abgestimmt auf die gestalterischen Ansprüche der hochwertigen Architektur beispielsweise bei repräsentativen öffentlichen oder privaten Bauten.

Jedes Photovoltaik-Modul der erfindungsgemäßen Fassadenplatte weist mindestens eine Solarzelle auf, die eine Vorderseite und eine einer Grundplatte des Photovoltaik-Moduls zugewandte Rückseite aufweist. Die Vorderseite der Solarzelle ist mit einer auf der Grundplatte des Moduls angeordneten, elektrisch leitenden Schicht verbunden, wobei die Grundplatte aus zumindest einer elektrisch isolierenden Schicht besteht, welche auf der der Solarzelle abgewandten Seite eine erste, strukturierte und elektrisch leitende Schicht aufweist, die mit der Vorderseite der Solarzelle elektrisch verbunden ist. Auf der gegenüberliegenden Seite der isolierenden Schicht ist eine zweite strukturierte und elektrisch leitende Schicht angeordnet, die mit der Rückseite der Solarzelle elektrisch verbunden ist.

Vorzugsweise weist jedes Photovoltaik-Modul eine die mindestens eine Solarzelle abdeckende transparente Schicht, insbesondere Glasscheibe, auf, über welche das Photovoltaik-Modul im Zuge eines Autoklaven-Prozesses mit der Unterseite des Trägers verbunden/laminiert ist.

Das insbesondere übergroße Trägerglas wird vorzugsweise mit einer Spezialbeschichtung versehen, die das einfallende Licht zu mindestens 80%, vorzugsweise zu mindestens 85% und noch bevorzugter zu mindestens 90% durch die Glasplatte passieren lässt.

Die Oberflächenbeschichtung ist insbesondere derart ausgebildet, dass für den menschlichen Beobachter von außen, d.h. mit Sicht auf die Oberseite des in Gestalt einer monolithischen Glasplatte ausgeführten Trägers, eine Struktur der Anordnung der Photovoltaik-Module und/oder die Photovoltaik-Module nicht oder zumindest nicht vollständig sichtbar sind. So entsteht der Eindruck eines übergroßen Wandverkleidungspanels aus Glas, welches aber technisch gesehen aus vielen einzelnen Standard-PV-Modulen besteht.

Vorzugsweise enthält die als Träger dienende monolithisch ausgeführte Glasplatte 60 Gew.-% bis 75 Gew.-% Siliziumoxid, 0 Gew.-% bis 10 Gew.-% ALzOs, 0 Gew.-% bis 5 Gew.-% BzOs, 5 Gew.-% bis 15 Gew.-% CaO, 0 Gew.-% bis 10 Gew.-% MgO, 5 Gew.-% bis 20 Gew.-% Na2O, 0 Gew.-% bis 10 Gew.-% KzO, 0 Gew.-% bis 5 Gew.-% BaO, > 0,2 Gew.-% bis 0,4 Gew.-% SO₃, 0 Gew.-% bis 0,015 Gew.-% FezOs und ein Verhältnis FeO zu Fe₂O₃ von 0,2 bis 0,4, besonders bevorzugt etwa 0 Gew.-% B₂O₃ und etwa 0 Gew.-% BaO.

Insbesondere ist der in Gestalt einer monolithisch ausgeführten Glasplatte ausgeführte Träger als eine vollvorgespannte Glasscheibe oder als eine Scheibe aus teilvorgespanntem Glas ausgeführt. Mit diesem Aufbau wird - aufgrund der Glasscheibe aus vorgespanntem Glas - eine statisch selbsttragende Struktur geschaffen.

Gemäß Realisierungen des erfindungsgemäßen Konstruktionselements sind der in Gestalt einer monolithisch ausgeführten Glasplatte ausgeführte Träger und die Vielzahl von in einer Reihe oder in einem Array angeordnete Photovoltaik-Module zu einer statisch selbsttragenden Einheit zusammengefasst sind, und zwar vorzugsweise derart, dass das Konstruktionselement im Einbauzustand nur einseitig oder maximal zweiseitig gehalten werden muss.

Diese statisch selbsttragende Eigenschaft des ballistischen Blocks wird dadurch erzielt, dass auf der Rückseite des in Gestalt einer monolithisch ausgeführten Glasplatte ausgeführten Trägers die PV-Module auflaminiert sind, während der in Gestalt einer monolithisch ausgeführten Glasplatte ausgeführte Träger nicht aus Floatglas besteht, sondern aus vorgespanntem Glas besteht. Dadurch ist die statisch selbsttragende Eigenschaft des Konstruktionselements.

Unter dem Begriff "statisch selbsttragend" ist im Bauwesen eine Struktur zu verstehen, welche die tragende Funktion übernimmt. Es gibt keine Trennung zwischen rein auf Biegung/Torsion oder schubbelasteten Bauteilen und Teilen. Vielmehr wirken alle Teile statisch als Schalen und nehmen in ihrer Gesamtheit die eingeleiteten Kräfte auf. Auch sind keine Rahmenstrukturen etc. zum Halten des ballistischen Blocks bzw. der Glasscheiben des ballistischen Blocks notwendig, da der ballistische Block als solcher statisch selbsttragend ist.

Die Steifigkeit, welche notwendig ist, um insbesondere das Konstruktionselement statisch selbsttragend auszuführen, kann insbesondere nur erzielt werden, indem vorgespanntes Glas für den in Gestalt einer monolithisch ausgeführten Glasplatte ausgeführten Träger des Konstruktionselements verwendet wird. Hierbei hat sich gezeigt, dass ein Konstruktionselement, das aus Floatglas aufgebaut ist, keine selbsttragende Eigenschaft im statischen Sinne aufweist.

Auf der Oberseite der monolithisch ausgeführten Glasplatte kann eine Oberflächenstruktur mit einem Mittenrauwert Ra von 2,0 µm bis 3,5 µm ausgebildet sein. Mit diesen Mittenrauwerten wird eine besonders hohe Lichtstreuung, bei gleichzeitig hoher Energietransmission erzielt.

Das erfindungsgemäße Fassadenelement kann insbesondere in Kaltfassaden als äußere Schale die Wetterschutzfunktion für den Warmbereich des Gebäudes übernehmen und dient darüber hinaus als prägendes Fassadengestaltungselement. Dadurch, dass das Fassadenelement auch Übergrößen aufweisen kann, lässt sich ein optisch geschlossenes Erscheinungsbild erreichen. Auch bei außergewöhnlichen Fassadengeometrien lässt sich die Form der Module und ihrer Zellen perfekt an die Gebäudekanten anpassen.

Auf der Oberseite und/oder Unterseite des in Gestalt einer monolithisch ausgeführten Glasplatte ausgeführten Trägers ist vorzugsweise eine Oberflächenbeschichtung vorgesehen, welche ausgebildet ist, auf die Oberseite einfallendes Sonnenlicht zu mindestens 80%, vorzugsweise zu mindestens 85% und noch bevorzugter zu mindestens 90% durch die Glasplatte passieren zu lassen.

Insbesondere ist die Oberflächenbeschichtung derart ausgebildet, dass für den menschlichen Beobachter von außen, d.h. in Draufsicht auf die Oberseite des in Gestalt einer monolithisch ausgeführten Glasplatte ausgeführten Trägers, eine Struktur der Anordnung der Photovoltaik-Module und/oder die Photovoltaik-Module nicht oder zumindest nicht vollständig sichtbar sind.

Auf diese Weise sind wahlweise transparente Fassadenelemente mit Transparenzgrad nach Wahl und höchsten Solarerträgen, farbige Fassadenelemente mit dezent sichtbaren PV-Zellen und höchsten Energie-Erträgen oder Hochwertige, homogen einfarbige Fassadenelemente ohne sichtbare PV-Technik realisierbar.

Alternativ oder zusätzlich hierzu kann auf Unterseite des in Gestalt einer monolithisch ausgeführten Glasplatte ausgeführten Trägers eine Folienlage mit einer insbesondere unter Temperatureinwirkung aktivierbaren Adhäsionsschicht und vorzugsweise mit einer Oberflächenbeschichtung vorgesehen sein, welche ausgebildet ist, auf die Oberseite einfallendes Sonnenlicht zu mindestens 80%, vorzugsweise zu mindestens 85% und noch bevorzugter zu mindestens 90% durch die Glasplatte passieren zu lassen.

Insbesondere können mit der Erfindung übergroße BIPV-Fassadenelemente realisiert werden, die zu den derzeit produzierbaren Größen der Fassadengläser mit 20 m x 3,6 m passen

Die Erfindung betrifft ferner ein Verfahren zum Herstellen eines Konstruktionselements der zuvor genannten erfindungsgemäßen Art, d.h. zum Herstellen eines Konstruktionselements in Gestalt einer insbesondere sandwichartig aufgebauten Fassadenplatte. Das Verfahren weist insbesondere die folgenden Verfahrensschritte auf:
- Bereitstellen einer monolithisch ausgeführten Glasplatte, welche eine Oberseite aufweist, die die Außenseite des insbesondere als Fassadenplatte ausgeführten Konstruktionselements bilden wird;
- Bereitstellen einer Vielzahl von in einer Reihe oder in einem Array angeordneten Photovoltaik-Module; und
- Auflaminieren der Photovoltaik-Module auf eine der Oberseite gegenüberliegenden Unterseite der monolithisch ausgeführten Glasplatte mit Hilfe eines Autoklaven-Prozesses.

Dabei ist insbesondere vorgesehen, dass die monolithisch ausgeführte Glasplatte eine Fläche von mindestens 5 m² und vorzugsweise von mindestens 10 m² aufweist.

Bei den Photovoltaik-Modulen handelt es sich insbesondere um eigenständige Module, welche als solche bereits betriebsfertig angeschlossen und insbesondere geprüft sind, wobei insbesondere jedes Photovoltaik-Modul als ein vollständig verkapseltes Modul ausgeführt ist.

Nachfolgend wird unter Bezugnahme auf die beiliegenden Zeichnungen eine exemplarische Ausführungsform der Erfindung näher beschrieben.

Es zeigen:
- FIG. 1: schematisch und in einer Draufsicht eine erste exemplarische Ausführungsform des Konstruktionselements gemäß der Erfindung, wobei das Konstruktionselement als BIPV-Fassadenplatte ausgeführt ist; und
- FIG. 2: schematisch und in einer Schnittansicht entlang der Linie A-A und B-B in FIG. 1 die exemplarische Ausführungsform des erfindungsgemäßen Konstruktionselements.

Bauwerkinterne Photovoltaik ist inzwischen ein wachsender Markt, der "ungenutzte" Außenflächen von Gebäuden verwendet, um damit nachhaltigen Strom zu produzieren. Um diese an Wänden angebrachten Photovoltaik-Module in die Gebäudegestaltung zu integrieren, ist es derzeit üblich, dass mittels verschiedener lichtdurchlässiger farbiger Beschichtungen das eigentliche Photovoltaik-Modul "versteckt" wird.

Ziel der vorliegenden Erfindung hingegen ist es, übergroße Photovoltaik-Module anzugeben, die zu den derzeit produzierbaren Größen der Fassadengläser mit 20 m x 3,6 m passen.

Bei bauwerkintegrierter Photovoltaik handelt es sich um Bauelemente, die zusätzlich zur Stromgewinnung "klassische" Funktionen, wie Wärmedämmung, Wind- und Wetterschutz oder auch architektonische Funktionen übernehmen. Besonders in der Fassade erfüllen bauwerkintegrierte Photovoltaik-Komponenten Aufgaben, die deutlich über die Stromgewinnung hinausgehen.

Die erfindungsgemäßen Fassadenelementen mit den vollständig integrierten Solarmodulen können im transparenten und im nicht-transparenten Bereich, aber auch als vorgehängte, hinterlüftete Fassaden eingesetzt werden.

Insbesondere individuell farblich gestaltete und/oder oberflächentexturierte und als BIPV-Module ausgeführte Fassadenelemente der vorliegenden Erfindung können sehr gut als architektonisches Gestaltungselement für Gebäude oder ganze Stadteile eingesetzt werden.

Die als BIPV-Module ausgeführten Fassadenelemente der vorliegenden Erfindung können in so genannten Plattenlaminatoren effizient und in großen Stückzahlen hergestellt werden. Dieses Verfahren ist besonders schonend und vermeidet die Beschädigung der verlöteten sensiblen Silizium-Elemente der PV-Module. Das spezielle Verfahren benötigt aber zum einen eine teure Anschaffung von vollautomatischen Plattenlaminatoren und zum anderen ist die herstellbare Größe durch deren Verfügbarkeit auf maximal 2 m x 3 m eingeschränkt.

Für übergroße Gläser, beispielsweise Fassadengläser mit einer Größe von 20 m x 3,6 m, wird häufig der so genannte Autoklaven-Prozess zum Verbinden verwendet. Der Autoklaven-Prozess, der für diese Glasgrößen zum Verbinden verwendet wird, ist jedoch für die Herstellung von PV-Modulen ungeeignet, da die empfindlichen Halbleiterzellen der PV-Module dabei brechen würden.

Auch schon das Bestücken in individuellen Anordnungen ohne entsprechende verfügbare Automatisierung ist für die empfindlichen Zellen hochriskant. So wäre ein produktionsbedingter kleiner Schaden an nur einer Zelle eines PV-Moduls der Totalverlust eines gesamten aufwendig hergestellten übergroßen teuren Moduls.

Zusätzlich ist es auch nicht möglich, die Abmessungen von PV-Modulen beliebig groß zu wählen, da die entsprechende Leistung eines solchen Moduls zu hoch wäre. Für solch ein Modul gibt es keine passenden Anschlussleitungen oder Wechselrichter. Das bedeutet, dass auch elektrotechnisch gesehen Grenzen der Machbarkeit bestehen.

Auch so genannte Dünnschichtmodule werden in einem hochkomplexen Prozess vollautomatisiert in nur einer einheitlichen Größe hergestellt. Dünnschichtmodule sind zwar vom Laminationsprozess gesehen unempfindlicher, aber in der Herstellungsgröße auch anlagentechnisch auf Größen von etwa 1,6 m x 0,64 m extrem begrenzt.

Demgemäß besteht ein mit Hilfe der vorliegenden Erfindung erfüllter Bedarf, eine Fassadenplatte mit bauwerkintegrierter Photovoltaik anzugeben, wobei die aus architektonischer Sicht gewünschten Übergroßen von beispielsweise 20 m x 3,6 m realisierbar sind.

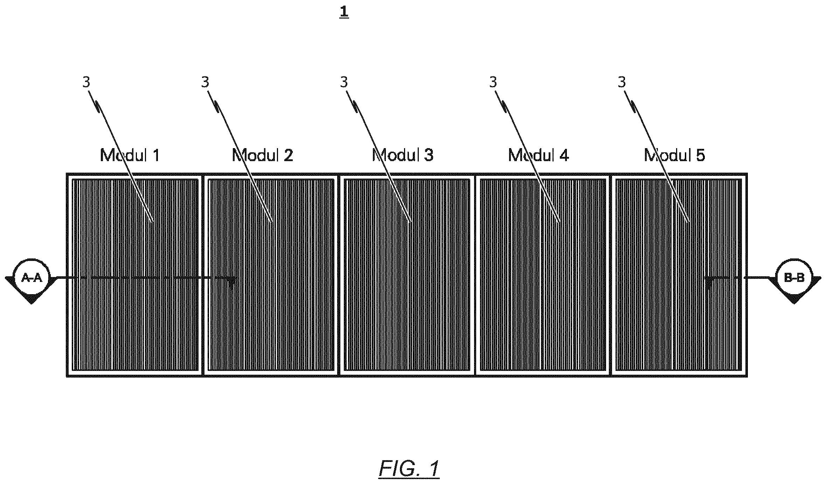

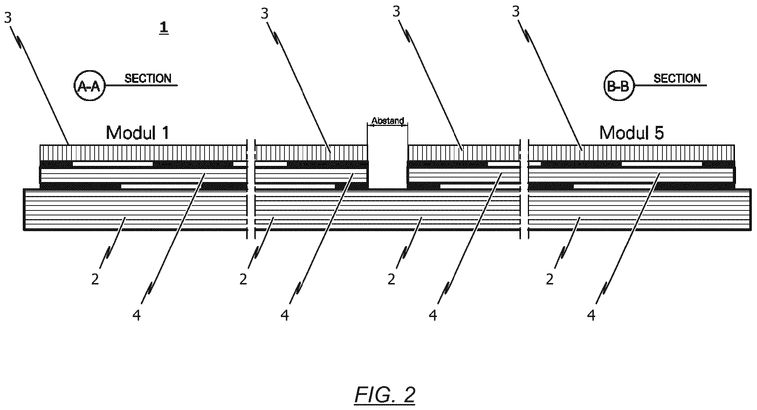

FIG. 1 zeigt schematisch und in einer Draufsicht eine erste exemplarische Ausführungsform des Konstruktionselements 1 gemäß der Erfindung, wobei das Konstruktionselement 1 als BIPV-Fassadenplatte ausgeführt ist, während FIG. 2 schematisch und in einer Schnittansicht entlang der Linie A-A und B-B in FIG. 1 die exemplarische Ausführungsform des erfindungsgemäßen Konstruktionselements 1 zeigt.

Kurz zusammengefasst handelt es hierbei um ein Konstruktionselement 1 in Gestalt einer insbesondere sandwichartig aufgebauten Fassadenplatte, wobei das Konstruktionselement 1 einen Träger in Gestalt einer monolithisch ausgeführten Glasplatte 2 aufweist. Die Glasplatte 2 weist eine Oberseite auf, die die Außenseite des insbesondere als Fassadenplatte ausgeführten Konstruktionselements 1 bildet.

Das Konstruktionselement 1 weist ferner eine Vielzahl von in einer Reihe oder in einem Array angeordnete Photovoltaik-Module 3 auf, wobei die Photovoltaik-Module 3 im Zuge eines Autoklaven-Prozesses auf eine der Oberseite gegenüberliegenden Unterseite des Trägers 2 auflaminiert sind.

Jedes Photovoltaik-Modul 3 weist mindestens eine Solarzelle aufweist, die eine Vorderseite und eine einer Grundplatte des Photovoltaik-Modul 3s zugewandte Rückseite aufweist, wobei die Vorderseite der Solarzelle mit einer auf der Grundplatte des Photovoltaik-Modul 3s angeordneten elektrisch leitenden Schicht verbunden ist, wobei die Grundplatte aus zumindest einer elektrisch isolierenden Schicht besteht, welche auf der der mindestens einen Solarzelle abgewandten Seite eine erste strukturierte, elektrisch leitende Schicht aufweist, die mit der Vorderseite der Solarzelle elektrisch verbunden ist, und wobei auf der gegenüberliegenden Seite der isolierenden Schicht eine zweite strukturierte, elektrisch leitende Schicht angeordnet ist, die mit der Rückseite der mindestens einen Solarzelle elektrisch verbunden ist.

Jedes Photovoltaik-Modul 3 weist eine die mindestens eine Solarzelle abdeckende transparente Schicht, insbesondere Glasscheibe 4, auf, über welche das Photovoltaik-Modul 3 stoffschlüssig mit der Unterseite des Trägers 2 verbunden ist.

Bei den Photovoltaik-Modulen 3 handelt es sich insbesondere um eigenständige Module handelt, welche als solche bereits betriebsfertig angeschlossen und insbesondere geprüft sind. Insbesondere ist jedes Photovoltaik-Modul 3 als ein vollständig verkapseltes Modul ausgeführt.

Die Erfindung ist nicht auf das in den Zeichnungen gezeigte Ausführungsbeispiel beschränkt, sondern ergibt sich aus einer Zusammenschau sämtlicher hierin offenbarter Merkmale.

Insbesondere ist es in diesem Zusammenhang denkbar, dass bei dem in FIG. 1 und FIG. 2 schematisch gezeigten Konstruktionselement 1 auf der Oberseite und/oder Unterseite des in Gestalt einer monolithisch ausgeführten Glasplatte 2 ausgeführten Trägers 2 eine Oberflächenbeschichtung vorgesehen ist, welche ausgebildet ist, auf die Oberseite einfallendes Sonnenlicht zu mindestens 80%, vorzugsweise zu mindestens 85% und noch bevorzugter zu mindestens 90% durch die Glasplatte 2 passieren zu lassen.

Die Oberflächenbeschichtung kann insbesondere derart ausgebildet sein, dass für den menschlichen Beobachter von außen, d.h. in Draufsicht auf die Oberseite des in Gestalt einer monolithisch ausgeführten Glasplatte 2 ausgeführten Trägers 2, eine Struktur der Anordnung der Photovoltaik-Module 3 und/oder die Photovoltaik-Module 3 nicht oder zumindest nicht vollständig sichtbar sind.

### Bezugszeichenliste

- 1: Konstruktionselement/Fassadenelement
- 2: Träger/Glasplatte
- 3: PV-Modul
- 4: Abdeckschicht/Glasplatte des PV-Moduls

## Patentansprüche

1. Konstruktionselement (1) in Gestalt einer insbesondere sandwichartig aufgebauten Fassadenplatte, wobei das Konstruktionselement (1) Folgendes aufweist:
- einen Träger in Gestalt einer monolithisch ausgeführten Glasplatte (2), welche eine Oberseite aufweist, die die Außenseite des insbesondere als Fassadenplatte ausgeführten Konstruktionselements (1) bildet; und
- eine Vielzahl von in einer Reihe oder in einem Array angeordnete Photovoltaik-Module (3),
wobei die Photovoltaik-Module (3) auf eine der Oberseite gegenüberliegenden Unterseite des Trägers (2) stoffschlüssig auflaminiert sind.

2. Konstruktionselement (1) nach Anspruch 1,
wobei die Photovoltaik-Module (3) mit Hilfe eines insbesondere temperierten Vakuumprozesses stoffschlüssig auf eine der Oberseite gegenüberliegenden Unterseite des Trägers (2) auflaminiert sind.

3. Konstruktionselement (1) nach Anspruch 1 und insbesondere nach Anspruch 2, wobei die Photovoltaik-Module (3) im Zuge eines Autoklaven-Prozesses auf eine der Oberseite gegenüberliegenden Unterseite des Trägers (2) auflaminiert sind.

4. Konstruktionselement (1) nach einem der Ansprüche 1 bis 3,
wobei jedes Photovoltaik-Modul (3) mindestens eine Solarzelle aufweist, die eine Vorderseite und eine einer Grundplatte des Photovoltaik-Moduls (3) zugewandte Rückseite aufweist, wobei die Vorderseite der Solarzelle mit einer auf der Grundplatte des Photovoltaik-Moduls (3) angeordneten elektrisch leitenden Schicht verbunden ist, wobei die Grundplatte aus zumindest einer elektrisch isolierenden Schicht besteht, welche auf der der mindestens einen Solarzelle abgewandten Seite eine erste strukturierte, elektrisch leitende Schicht aufweist, die mit der Vorderseite der Solarzelle elektrisch verbunden ist, und wobei auf der gegenüberliegenden Seite der isolierenden Schicht eine zweite strukturierte, elektrisch leitende Schicht angeordnet ist, die mit der Rückseite der mindestens einen Solarzelle elektrisch verbunden ist.

5. Konstruktionselement (1) nach Anspruch 4,
wobei jedes Photovoltaik-Modul (3) eine die mindestens eine Solarzelle abdeckende transparente Schicht, insbesondere Glasscheibe (4), aufweist, über welche das Photovoltaik-Modul (3) stoffschlüssig mit der Unterseite des Trägers (2) verbunden ist.

6. Konstruktionselement (1) nach einem der Ansprüche 1 bis 5,
wobei es sich bei den Photovoltaik-Modulen (3) um eigenständige Module handelt, welche als solche bereits betriebsfertig angeschlossen oder betriebsfertig anschließbar sind, und die insbesondere geprüft, insbesondere fertig zertifiziert sind.

7. Konstruktionselement (1) nach einem der Ansprüche 1 bis 6,
wobei jedes Photovoltaik-Modul (3) als ein vollständig verkapseltes Modul ausgeführt ist.

8. Konstruktionselement (1) nach einem der Ansprüche 1 bis 7,
wobei auf der Oberseite und/oder Unterseite des in Gestalt einer monolithisch ausgeführten Glasplatte (2) ausgeführten Trägers (2) eine Oberflächenbeschichtung vorgesehen ist, welche ausgebildet ist, auf die Oberseite einfallendes Sonnenlicht zu mindestens 80%, vorzugsweise zu mindestens 85% und noch bevorzugter zu mindestens 90% durch die Glasplatte (2) passieren zu lassen, wobei die Oberflächenbeschichtung vorzugsweise derart ausgebildet ist, dass für den menschlichen Beobachter von außen, d.h. in Draufsicht auf die Oberseite des in Gestalt einer monolithisch ausgeführten Glasplatte (2) ausgeführten Trägers (2), eine Struktur der Anordnung der Photovoltaik-Module (3) und/oder die Photovoltaik-Module (3) nicht oder zumindest nicht vollständig sichtbar sind.

9. Konstruktionselement (1) nach einem der Ansprüche 1 bis 8,
wobei auf Unterseite des in Gestalt einer monolithisch ausgeführten Glasplatte (2) ausgeführten Trägers (2) eine Folienlage mit einer insbesondere unter Temperatureinwirkung aktivierbaren Adhäsionsschicht und vorzugsweise mit einer Oberflächenbeschichtung vorgesehen ist, welche ausgebildet ist, auf die Oberseite einfallendes Sonnenlicht zu mindestens 80%, vorzugsweise zu mindestens 85% und noch bevorzugter zu mindestens 90% durch die Glasplatte (2) passieren zu lassen.

10. Konstruktionselement (1) nach einem der Ansprüche 1 bis 9,
wobei das Konstruktionselement (1) und insbesondere der in Gestalt einer monolithisch ausgeführten Glasplatte (2) ausgeführte Träger eine Fläche von mindestens 4 m² und vorzugsweise von mindestens 10 m² aufweist.

11. Konstruktionselement (1) nach einem der Ansprüche 1 bis 10,
wobei der in Gestalt einer monolithisch ausgeführten Glasplatte (2) ausgeführte Träger (2) als eine gebogene Glasscheibe mit einem vorab festgelegten oder festlegbaren Biegeradius ausgeführt ist; und/oder
wobei der in Gestalt einer monolithisch ausgeführten Glasplatte (2) ausgeführte Träger (2) als eine vollvorgespannte Glasscheibe oder als eine Scheibe aus teilvorgespanntem Glas ausgeführt ist.

12. Konstruktionselement (1) nach einem der Ansprüche 1 bis 11,
wobei der in Gestalt einer monolithisch ausgeführten Glasplatte (2) ausgeführte Träger (2) und die Vielzahl von in einer Reihe oder in einem Array angeordnete Photovoltaik-Module (3) zu einer statisch selbsttragenden Einheit zusammengefasst sind, derart, dass das Konstruktionselement (1) im Einbauzustand nur einseitig oder maximal zweiseitig gehalten werden muss.

13. Verfahren zum Herstellen eines Konstruktionselements (1) in Gestalt einer insbesondere sandwichartig aufgebauten Fassadenplatte, insbesondere zum Herstellen eines Konstruktionselements (1) nach einem der Ansprüche 1 bis 12, wobei das Verfahren die folgenden Verfahrensschritte aufweist:
• Bereitstellen einer monolithisch ausgeführten Glasplatte (2), welche eine Oberseite aufweist, die die Außenseite des insbesondere als Fassadenplatte ausgeführten Konstruktionselements (1) bilden wird;
• Bereitstellen einer Vielzahl von in einer Reihe oder in einem Array angeordneten Photovoltaik-Module (3); und
• Auflaminieren der Photovoltaik-Module (3) auf eine der Oberseite gegenüberliegenden Unterseite der monolithisch ausgeführten Glasplatte (2) insbesondere mit Hilfe eines Autoklaven-Prozesses.

14. Verfahren nach Anspruch 13,
wobei die monolithisch ausgeführte Glasplatte (2) eine Fläche von mindestens 4 m² und vorzugsweise von mindestens 10 m² aufweist.

15. Verfahren nach Anspruch 13 oder 14,
wobei es sich bei den Photovoltaik-Modulen (3) um eigenständige Module handelt, welche als solche bereits betriebsfertig angeschlossen und insbesondere geprüft, insbesondere fertig zertifiziert sind, wobei insbesondere jedes Photovoltaik-Modul (3) als ein vollständig verkapseltes Modul ausgeführt ist.
